# EUROPEAN PATENT APPLICATION

(11) **EP 2 584 596 A2**
(43) Date of publication of application: **24.04.2013**
(21) Application number: 12189031.3
(22) Date of filing: 18.10.2012
(51) Int. Cl.: H01L 21/66, G01R 1/073

(54) **Testing device for testing wafers for electronic circuits and related method**

(30) Priority: 18.10.2011 IT UD20110166; 10.02.2012 US 201261597505 P
(71) Applicant: Applied Materials Italia Srl, 31048 San Biagio di Callalta (IT)
(72) Inventor: Tonini, Diego, 31100 Treviso (IT); Voltan, Alessandro, 31050 Morgano (TV) (IT); Galiazzo, Marco, 35127 Padova (IT); Martire, Marco, 87030 Longobardi (CS) (IT)
(74) Representative: Petraz, Gilberto Luigi

(57) **Abstract**

A testing device (100) is disclosed for testing wafer (11) of electronic circuits, comprising a measuring head (10) provided with three functional blocks (12, 13, 14), each able to move independently from the others, to carry out different resistive measurements on a cell or wafer (11). Each of the functional blocks (12, 13, 14) supports respective measuring probes (15), suitable to be placed into contact with metallization lines or fingers (16), made on the wafers (11).

## Description

### BACKGROUND OF THE INVENTION

### Field of the Invention

Aspects of the present invention generally relate to methods and devices for testing plates, such as substrates used to form solar cells used in solar or photovoltaic factories or plants. Further aspects relate to mapping the contact and line resistivity of metalized lines (for example fingers or bus bars) in solar and photovoltaic cells, performed directly in the production step of the cells.

Embodiments can be used in a plant for the production of plates, or substrates, for use in forming electronic circuits. In some embodiments, methods and devices may be used to carry out a series of quality tests of a resistive type on plates (e.g., wafers or substrates) with a silicon or alumina base, such as photovoltaic cells or green-tape circuits.

### Description of the Related Art

Resistive contacts have a great importance for the quality and efficiency of electronic circuits. Therefore it is necessary to verify them carefully and thoroughly. This becomes even more important when increasing the density of the components that are present in the plates used to make the circuits.

Various techniques may be used in the electric testing procedures for plates of this type. Generally, tests are carried out on sample plates in a separate procedure, with respect to the normal production of the plates.

One of these techniques, widely used, is called TLM (Transmission Line Model). In TLM techniques, the relevant parameters concerning the contact resistance are found from a numerical regression of a curve obtained by interpolating n values obtained by carrying out a plurality of measurements of the resistance between adjacent or distant pairs of metallization lines, for example fingers or bus bars.

This technique has some disadvantages, in particular due to the limitations of the measuring equipment used, errors in measuring the metallization line, and errors deriving from the incorrect preparation of the strips subjected to the test. There may also be errors due to incorrect hypotheses assumed in carrying out the calculation.

For a more thorough examination of the problems connected to the use of this measuring technique please refer to the article "Development of the transmission line method for measuring contact to high sheet resistance emitters with improved accuracy" by Kirk et al., 25th European Photovoltaic Solar Energy Conference and Exhibition/5th World Conference on Photovoltaic Energy Conversion, 6-10 September 2010, Valencia, Spain.

Other techniques used to make such measurements of the contact resistivity are those known as "Squares Pattern" and "Dotted Pattern." These techniques may be carried out by generating predefined metallization patterns on sample plates and then generating flows of current through the metalized areas so as to find the resistance curves in ratio to the contact area.

The article "Contact Resistance Measurement Techniques for Ag Thick-Film Screen-Printed Contacts to Solar Cells" by M. Melczarsky et al., IEEE Transactions 2009, compares these two techniques with TLM, concluding that the latter is not the most suitable for measuring screen-printed contacts due to the sensitivity of the slope of this method and to the separation of the contact feet which characterizes this type of metallization technique.

The other two techniques mentioned above, although they are an improvement, also have disadvantages and in particular the problem of finding the data of the measurements through interpolation of a series of different measurements, therefore suffering the disadvantages relating to the interpolation techniques and the influence that the slope of the interpolation curve obtained can have.

In measuring the contact resistivity with the TLM technique, it is hypothesized that the substrate on which the contacts are deposited is uniformly doped. However, in the event of the so-called selective emitter technology, the substrate has a big variation in concentration precisely under the contacts, which negatively influences the result of the measurement.

Therefore, a need exists to develop improved techniques and equipment. In particular, a need exists to develop techniques and equipment to carry out tests on plates for electronic circuits to be used as solar/photovoltaic cells, in which the disadvantages of the state of the art can be overcome or at least greatly limited.

### SUMMARY OF THE INVENTION

Certain embodiments discussed herein carry out measurements of the values of line and contact resistivity directly, not by means of interpolation. Accordingly, the following advantages have been obtained: preventing problems connected to mathematical factors in forming the interpolation curve; being able to perform the measurements even in the production line itself, therefore without requiring test procedures that are separate and detached from production; being able to carry out corrections in line, if verifications find defects or inaccuracies in the execution; being able to map the contact resistivity on the portion of cell subjected to testing, unlike in the TLM technique which generally provides a single mean value of resistivity measured on the testing structure; allowing for measurement of the contact resistivity on solar cells with selective emitter technology, where the emitter has a variation in the doping under the contact. Further advantages can be realized by not requiring specific and auxiliary testing structures. In addition, embodiments discussed herein are easily adaptable to any grid structure that is usable. The Applicant has devised, tested and described these embodiments to overcome the shortcomings of the state of the art and to obtain these and other purposes and advantages.

Particular embodiments are set forth and characterized in the independent claims, while the dependent claims describe other characteristics or variants of the embodiments provided.

In accordance with the above purposes, in one embodiment, a testing device for testing a plate for electronic circuits is provided that comprises a measuring head structured in three distinct functional blocks, each able to move independently of the others so as to make distinct resistive measurements on a cell or plate (wafer or substrate) for electronic circuits emerging from a production line. Each functional block supports respective measuring probes, suitable to be placed into contact with the metallization lines made on the plates, so as to carry out the relative measurements.

In some embodiments, each of the probes consists of conductor wires, for example made of tungsten or other suitable metallic material. Other types of probes can equally be used, all of which shall come within the field of protection herein. In one form of embodiment, the conductor wires for each of the probes are advantageously at least four in number, and are disposed parallel to each other. The conductor wires may be placed into contact with the metallization lines present on the plates emerging from the production line, in order to carry out the measurement. In particular, two of the conductor wires are suitable to inject current, and another two are suitable to measure tension (or voltage).

In some embodiments, the conductor wires of at least one of the probes can be shared with the conductor wires of another of the probes. In a further embodiment, the configuration of one or more shared conductor wires allow for a total number of conductor wires in the device to be less than twelve.

In some embodiments, measuring is carried out sequentially, on a sample plate taken from the production line. Measuring may also provide a first step of insulating the metallization lines (fingers) by means of laser or mechanical cutting. The insulation operation has the function of creating specific measurement cells, to allow for collection of information from the measurement cells on the current without there being any dispersions thereof. For example, since the fingers of a solar cell are generally connected with each other, they create low-resistance paths through which the current tends to flow. Accordingly, the insulation step is necessary so as to oblige the flow of current to pass through the substrate, such as during the measuring of the total resistance and/or end contact resistance.

In further embodiments, the second step in the measuring provides to define or map a grid for constructing the elementary cells on which the measurement is to be made.

In some embodiments, a measuring head comprises three functional blocks. For each of the elementary cells, the three functional blocks that make up a measuring head are made to act in sequence. Respectively, a first functional block is used for measuring the sheet or surface resistance, a second functional block is used for measuring the total resistance, and a third functional block is used for measuring the contact end resistance.

In further embodiments, the three functional blocks have respective and autonomous measuring probes, which can be moved independently of each other at least in the vertical direction (e.g., moving nearer to or further away from the plate for electronic circuits). Accordingly, the measuring sequence can also be modified according to requirements and to specific applications.

From the measurements obtained overall from the three functional blocks, it is possible to perform a calculation, analytically, of the contact resistivity of the selected elementary cell, thus obtaining the result sought.

The measuring method can then be repeated for all the elementary cells into which the plate/wafer has been divided, so as to obtain an overall value of the contact resistivity of the plate on which the test is carried out.

One advantage of these embodiments is that they allow measuring the contact resistivity of plates for electronic circuits directly during the production step. A further advantage is that measurements are not limited to predetermined sizes of the grid and the elementary cells, which can be set and adapted on each occasion for the specific requirements and applications.

Another advantage derives from mapping the contact resistivity for each elementary cell while also measuring the sheet resistance, which at the end of the measuring, allows for the mapping of the sheet resistance to be obtained.

Yet another advantage derives from the measuring block of the total resistance having two pairs of probes, which can be used to carry out measurements at four points on any conductor. For example, it is possible to put the block along a finger to extract the relative value of the line resistance, that is, the resistance per unit of length of the finger measured.

In addition to the above embodiments, devices and methods for testing plates of electronic circuits are provided. It is to be understood that various embodiments may be used in combination with one another.

In one embodiment, a testing device is provided for testing plates of electronic circuits, the testing device comprising: a measuring head having first, second and third functional blocks, wherein each functional block is able to move independently from the others and is suitable for carrying out different resistive measurements on a cell or a plate; and wherein each of the functional blocks supports a plurality of measuring probes suitable to be placed into contact with one or more metallization lines or fingers disposed on the cell or the plate.

In another embodiment, each of the measuring probes comprises one or more conductor wires. In a further embodiment, the conductor wires are made of tungsten. Another embodiment provides that the plurality of measuring probes of at least one of the first, second or third functional blocks comprises four measuring probes, each measuring probe having at least one conductor wire, and at least two of the measuring probes are suitable to inject current and the two other measuring probes are suitable to perform measurements of tension. In a further embodiment, for each measuring probe the conductor wires are disposed substantially parallel to each other. Devices may further comprise a switch electrically connected to the measuring head so as to selectively activate at least one of the first, second or third functional blocks.

Other embodiments provide a method for testing plates of electronic circuits, the method comprising: insulating a plurality of metallization lines or fingers present on one or more plates of electronic circuits; mapping a grid for the construction of elementary cells on which to carry out a measurement; and activating a measuring head have first, second and third functional blocks such that each functional block acts in sequence to conduct a sequence of measuring steps comprising: measuring a surface resistance with the first functional block; measuring the total resistance with the second functional block; and measuring the resistance of the end contacts with the third functional block.

The method may further comprise using the measurements obtained overall from the first, second and third functional blocks to calculate the contact resistivity of one of the elementary cells. In another embodiment, the method may further comprise: repeating the sequence of measuring steps for all the elementary cells into which the plate of electronic circuits is divided; and obtaining the overall value of the contact resistivity of the plate. In a further embodiment, the insulating the metallization lines or fingers is carried out by laser or mechanical cutting.

In yet another embodiment, a testing device is provided for measuring solar cells comprising: a control unit; a source of current in electronic communication with the control unit; a voltmeter in electronic communication with the control unit; and a measuring head in electronic communication with the control unit, the measuring head having a first functional block, a second functional block and a third functional block, wherein each functional block is suitable for measuring one or more properties of a solar cell.

In a further embodiment, each of the first, second and third functional blocks comprise four measuring probes. Another embodiment provides that the first functional block is suitable for measuring sheet resistance of a unit area of the solar cell, the second functional block is suitable for measuring total resistance between two insulated fingers, and the third functional block is suitable for measuring contact end resistance using three adjacent fingers. In an additional embodiment, the probes on at least the second and third functional blocks are configured so that the position of the probes may be changed to adapt to the size or type of the solar cell being tested. In another embodiment, the four probes on one of the functional blocks may be raised or lowered independently from the other two functional blocks. Moreover, the four probes on one of the functional blocks may be raised or lowered by raising or lowering the functional block.

In another embodiment, the testing device further comprises a switch in electronic communication with the control unit and the measuring head. An additional embodiment provides that the switch is in electronic communication with the source of current, the voltmeter and each of the functional blocks. Another embodiment provides that the testing device further comprises a movement unit, wherein the movement unit is configured to move the solar cell being tested, and the movement unit further comprises the measuring head. Moreover, the testing device may further comprise an electric detection unit, wherein the electric detection unit comprises the source of current, the voltmeter and the switch.

### BRIEF DESCRIPTION OF THE DRAWINGS

So that the manner in which the above recited features can be understood in detail, a more particular description may be had by reference to embodiments, some of which are illustrated in the appended drawings. It is to be noted that the appended drawings illustrate only example embodiments for discussion, and are therefore not limiting of claim scope.

FIG. 1 provides a block diagram showing the testing device according to some embodiments.

FIG. 2 illustrates the base structure of a measuring head used in a testing device according to some embodiments.

FIG. 3 illustrates dimensional parameters for the configuration of the testing device of FIG. 1.

FIG. 4 illustrates an example application for measuring sheet resistance.

FIG. 5 provides a diagram showing an example of the operation of a first functional block of a testing device, which may be used to measure sheet resistance.

FIG. 6 provides a diagram showing an example of the operation of a second functional block of a testing device, which may be used to measure total resistance.

FIG. 7 provides a diagram showing an example of the operation of a third functional block of a testing device, which may be used to measure contact end resistance.

FIGS. 8a-d illustrate a sequence of forming a grid that precedes the execution of the measurements, according to some embodiments.

FIG. 9a-d illustrate a sequence of a measuring method, according to some embodiments.

It is contemplated that features of one embodiment may be beneficially incorporated in other embodiments without further recitation.

### DETAILED DESCRIPTION

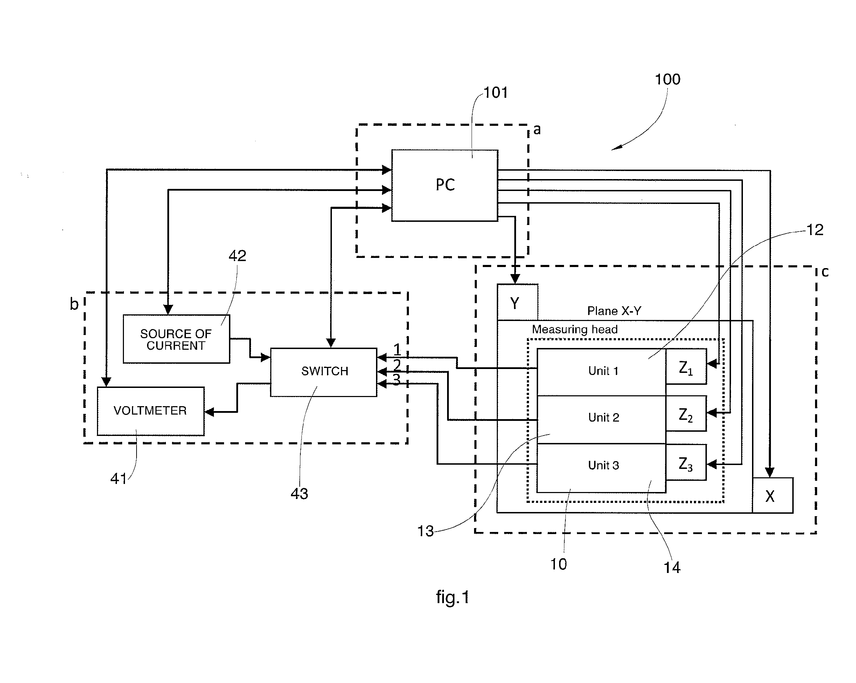

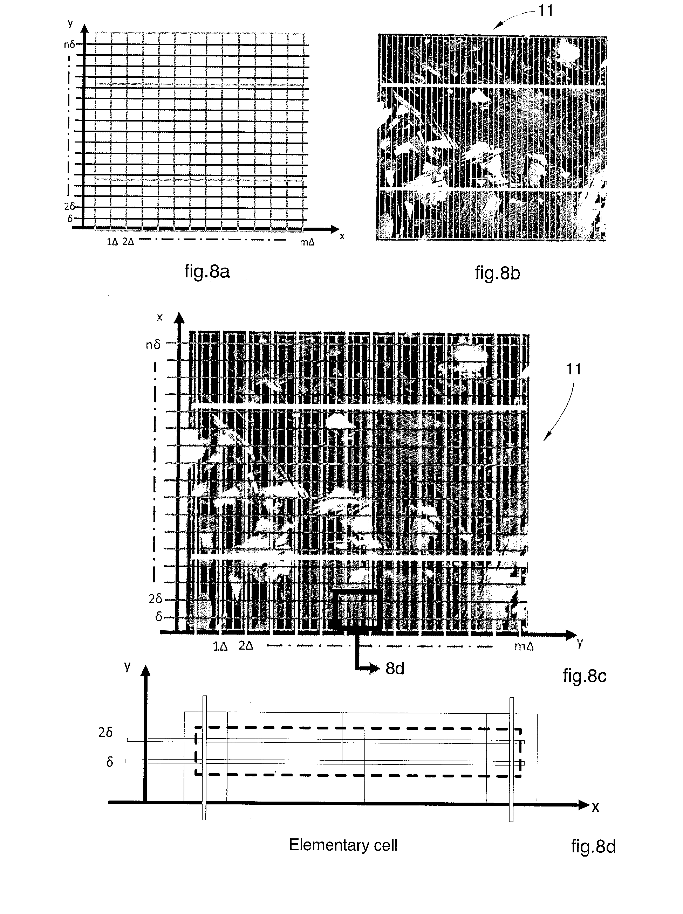

Embodiments of the invention may provide a testing device 100 for testing plates, such as a wafer 11 (shown in FIGS. 8b and 8c) or a substrate, which may be used to form at least part of a solar cell or at least part of an electronic circuit containing device. As illustrated in Figure 1, the testing device 100 may comprise three functional units "a," "b," and "c." One functional unit is a control unit, indicated by "a", which comprises at least a PC 101 (or other computing device). A second functional unit is an electric detection unit, indicated by "b." In this example, the electric detection unit "b" comprises a voltmeter 41, a source of current 42 and a switch 43. A third functional unit is a movement unit, indicated by "c." In this example, the movement unit "c" is configured to move both a measuring head 10 and the wafer 11.

The function of the control unit "a" is to manage the movement of the measuring head 10 and to control and command the electronic devices. To this end, the control unit "a" may use a software specifically dedicated to the application.

The electric detection unit "b" comprises at least the voltmeter 41 and the source of current 42, and has the functions of measuring tensions (or voltages) and feeding currents, respectively. In this example, the electric detection unit "b" further comprises the switch 43, which is configured so that the measuring unit can be selected on each occasion for measurement.

The movement unit "c" further comprises a series of actuators and linear motors (not shown) to move the wafer 11 on its lying plane xy according to the mapping of the grid (discussed further below), and to move the measuring head 10 on the plane z (orthogonal to the lying plane of the wafer 11) such as by moving the measuring head 10 nearer to or further away from the wafer 11 according to a sequence of measurements to be carried out. In some embodiments, the lying plane xy may be positioned horizontally, and the plane z may be positioned vertically.

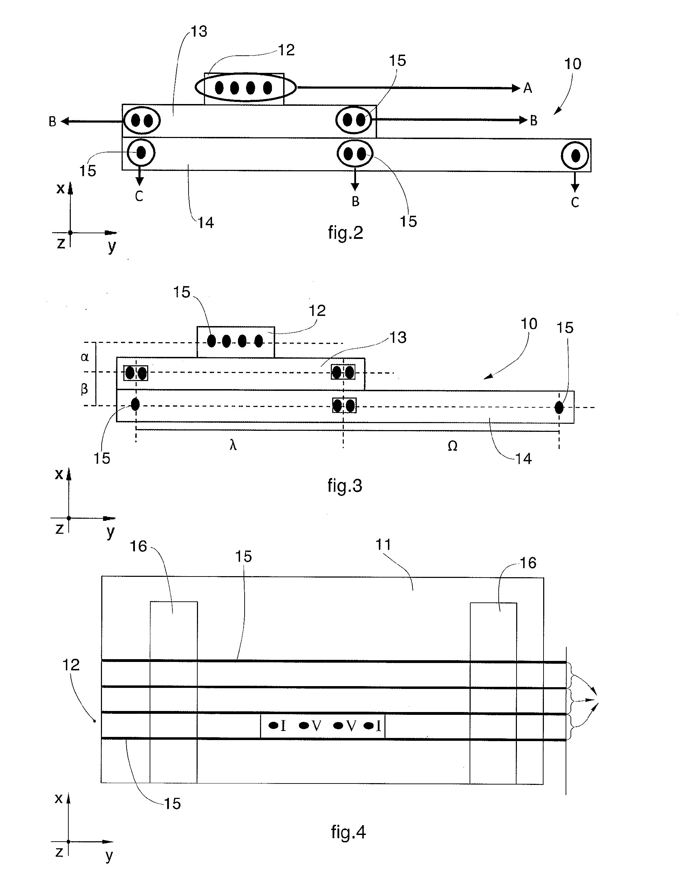

In the embodiments illustrated in FIGS. 2 and 3, the measuring head 10 comprises three functional blocks 12, 13 and 14, respectively, which are mobile independently of each other on the plane z, in respective directions z₁, z₂, z₃ (see, e.g., FIG. 1) in order to move nearer to or further away from the wafer 11 being measured, according to the sequence of measurements to be carried out.

In the embodiment shown, each functional block 12, 13 and 14 comprises four respective measuring probes 15, which each may comprise one or more conductor wires made of tungsten or other material suitable for the purpose. The measuring probes 15 are of a known type and their structure and configuration are not restrictive for practicing embodiments discussed herein. FIG. 2 further illustrates the positioning and grouping of the probes 15 on each of the functional blocks 12, 13 and 14. On functional block 12, a set of four adjacent probes "A" is provided. On functional block 13, two pairs of probes "B" are provided, set apart by a distance. And on functional block 14, a pair of probes "B" is provided in a central location, and positioned between two single probes "C," which are each set apart from the pair of probes "B." In some embodiments, the relative positioning of the groupings of probes (sets, pairs and singles) may be adjusted, such as to test a plate having different dimensions of components, or to test different types of plates.

FIG. 3 illustrates distances between the axes of individual probes 15 along the axis x and axis y in a horizontal plane. Distance A illustrates the distance along the y direction from an axis of a first probe in functional block 14 to a center axis between the second and third probes in the functional block 14. Distance λ also coincides with the distance between a central axis between the first and second probes in functional block 13 to a central axis between the third and fourth probes in the functional block 13. Distance Ω illustrates the distance along the y direction from the center axis between the second and third probes in the functional block 14 to the axis of the fourth probe in functional block 14. Accordingly, distances A and Ω can represent interaxes between one or more individual probes in a functional block. These interaxes distances can be varied between individual probes in a specific functional block as desired so as to adapt to the sizes and type of the specific wafer 11 to be tested. In this example, the axis of the first probe in functional block 14 is aligned with the center axis of the first set of probes (the first and second probes) in functional block 13, and the center axis of the set of the second and third probes in functional block 14 is aligned with the center axis of the second set of probes (the third and fourth probe) in functional block 13.

In a direction along the axis x, it can be seen that the probes of a specific functional block are aligned. For example the axes of the probes 15 in functional block 14 are each aligned. Distance β illustrates a distance along the x direction from the axes of the probes 15 in functional block 14 to the axes of the probes 15 in functional block 13. Similarly, distance α illustrates a distance along the x direction from the axes of the probes 15 in functional block 13 to the axes of the probes 15 in functional block 12. In this example, the respective distances in the y direction between probes in adjacent functional blocks are fixed. Similarly, the respective distances in the y direction between the functional blocks 12, 13 and 14 are fixed.

FIGS. 8a and 8b illustrate mapping a grid of a sample wafer 11. In some embodiments, a first step in taking a measurement is to map a grid of a sample wafer 11 to be tested. To construct the grid, the wafer 11 is divided into elementary cells (or other units suitable for measurement). In this example, the elementary cells are defined by a pitch δ along the axis y and by a pitch Δ along the axis x. The pitch δ can be chosen arbitrarily (or based on convenience or a desired preference), whereas the pitch Δ is a function of the width of the metalized lines or fingers (see, e.g., fingers 16 in FIG. 4) to be tested.

Once the elementary cells have been defined, the measuring procedure is started. This process is illustrated in FIGS. 8c and 8d. In this embodiment, the measuring head 10 is moved on command from the control unit 101 to carry out the sequence of measurements. Accordingly, measurements may be taken of each elementary cell or other unit.

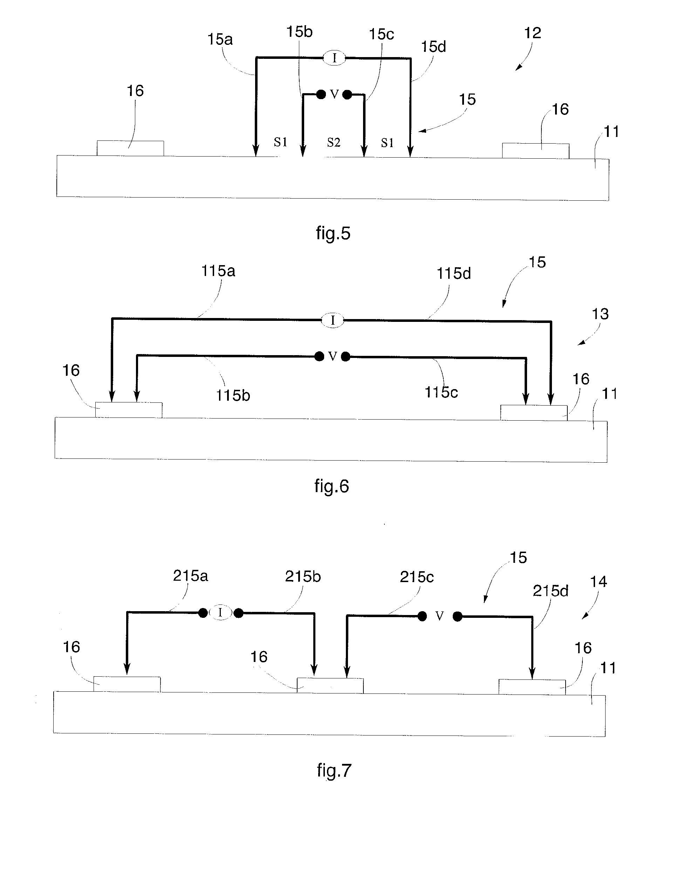

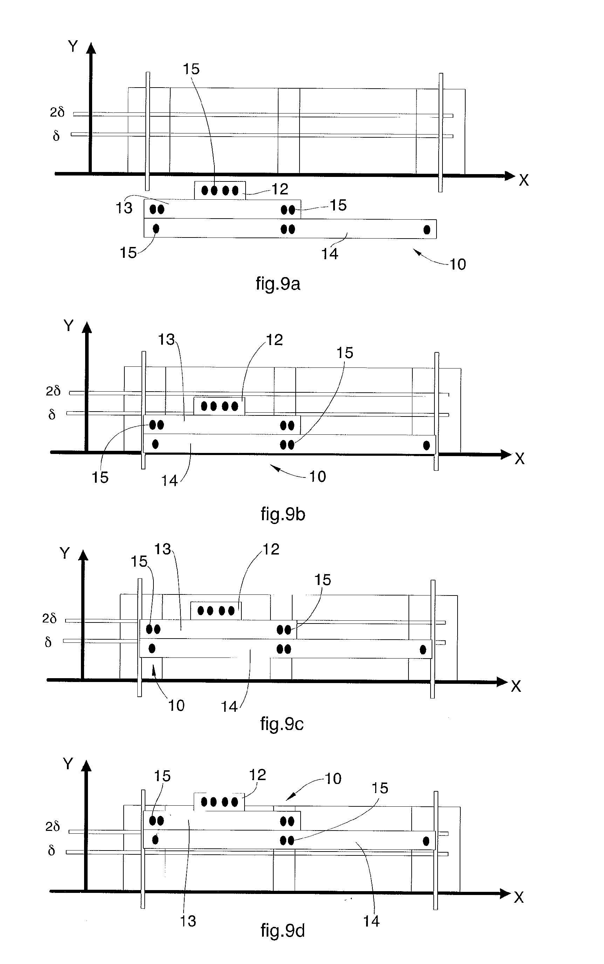

For example, the sequence of measurements for each elementary cell, starting from the first cell (see FIG. 8d), may provide first to drive the functional block 12 in order to measure the sheet resistance. FIG. 4 schematically shows the functioning of the block 12, where it is provided to lower (axis z) the four probes, indicated by 15a, 15b, 15c, 15d (FIG. 5), into contact with the intermediate space between two adjacent fingers 16, to emit current by the source of current 42 through the two external probes 15a and 15d and to detect the tension (or voltage) between the two internal probes 15b and 15c (FIGS. 5 and 9b).

FIGS. 6 and 9c illustrates additional steps after the sheet resistance has been measured (such as in one or more elementary cells). Next, the method provides to drive functional block 13, which is lowered onto wafer 11, to take the relative probes 15 into contact with the outermost fingers 16 on the sample wafer 11, to measure the total resistance. To obtain this measurement, the probes 115a, 115b are taken into contact with a first end finger 16, while the probes 115c and 115d are taken into contact with a second end finger 16 opposite the first finger 16. Current is made to circulate between the probes 115a and 115d and the tension (or voltage) between the probes 115b and 115c is measured.

When the total resistance has also been measured, the contact end resistance is measured (FIGS. 7 and 9d) using functional block 14, which is lowered into contact with wafer 11, to take the probes 15 into contact with three adjacent fingers 16. In particular, a first external probe 215a and the internal probe 215b adjacent to it are taken into contact with two adjacent fingers 16, probe 215c is taken into contact with the same finger as probe 215b whereas probe 215d is taken into contact with a third finger 16. Current is made to circulate between the two probes 215a and 215d and the tension between the two probes 215c and 215d is measured (FIG. 7).

When the measurement for the first elementary cell has been carried out, the sequential process is repeated for all the elementary cells.

From all the measurements carried out, by means of a suitable calculus algorithm, the measurement is obtained of the resistivity of the central finger of the reference cell, which thus determines the conclusion of the test on the sample wafer.

While the foregoing is directed to embodiments of the present invention, other and further embodiments of the invention may be devised without departing from the basic scope thereof, and the scope thereof is determined by the claims that follow.

## Claims

1. Testing device (100) for testing plates (11) for electronic circuits, wherein the plate comprises a substrate on which metallization lines, or fingers (16), are provided,
the device comprising a measuring head (10) provided with three functional blocks (12, 13, 14), each able to move independently from the others,
wherein each of said functional blocks (12, 13, 14) supports respective measuring probes (15),
wherein a first functional block (12) comprises probes (15) positioned and configured to measure the sheet resistance of the substrate,
a second functional block (13) comprises probes (15) positioned and configured to measure the total resistance between two opposite fingers (16), and
a third functional block (14) comprises probes (15) positioned and configured to measure the contact end resistance between three adjacent fingers.

2. Testing device as in claim 1, wherein each of said measuring probes (15) consists of conductor wires.

3. Testing device as in claim 2, wherein said conductor wires are made of tungsten.

4. Testing device as in claim 2 or 3, wherein the conductor wires, for each of said measuring probes (15), are at least four in number, of which at least two are suitable to inject current and two others to perform measurements of tension.

5. Testing device as in claim 2, 3 or 4, wherein in each measuring probe (15) said conductor wires are disposed substantially parallel to each other.

6. Testing device as in any claim hereinbefore, comprising switching means (43) connected to said measuring head (10) so as to selectively activate at least one of said functional blocks (12, 13, 14) of said measuring head (10).

7. Testing method for testing plates (11) for electronic circuits with the device as in any claim hereinbefore, wherein the plate comprises a substrate on which metallization lines, or fingers (16), are provided, the method comprising:
insulating the metalization lines or fingers (16) present on said plates (11);
defining or mapping a grid for the construction of elementary cells on which to carry out the measurement;
acting in sequence, for each of said elementary cells, the three functional blocks (12, 13, 14) which make up the measuring head (10), respectively a first functional block (12) to measure the sheet resistance, a second functional block (13) to measure the total resistance, and a third functional block (14) to measure the resistance of the end contacts.

8. Method as in claim 7, further comprising calculating, from the measurements obtained overall from said three functional blocks (12, 13, 14), the contact resistivity of the elementary cell selected.

9. Method as in claim 7 or 8, further providing to repeat the measuring sequence for all the elementary cells into which said plate (11) for electronic circuits is divided, so as to obtain the overall value of the contact resistivity of said plate (11).

10. Method as in claim 7, wherein said insulating the metalization lines or fingers (16) is carried out by means of laser or mechanical cutting.
